(19) Europäisches Patentamt
European Patent Office
Office européen des brevets

(11) Veröffentlichungsnummer : **0 536 086 A1**

# (12) EUROPÄISCHE PATENTANMELDUNG

(21) Anmeldenummer : **92810728.3**

(22) Anmeldetag : **24.09.92**

(51) Int. Cl.[5] : **G03F 7/027**, G03F 7/004, G03C 9/08

(30) Priorität : **03.10.91 CH 2922/91**

(43) Veröffentlichungstag der Anmeldung :
**07.04.93 Patentblatt 93/14**

(84) Benannte Vertragsstaaten :
**AT BE CH DE ES FR GB IT LI NL SE**

(71) Anmelder : **CIBA-GEIGY AG**
**Klybeckstrasse 141**
**CH-4002 Basel (CH)**

(72) Erfinder : **Schulthess, Adrian, Dr.**
**Uf em Bärg 22**
**CH-1734 Tentlingen (CH)**
Erfinder : **Steinmann, Bettina, Dr.**
**Les Russilles**
**CH-1724 Praroman (CH)**
Erfinder : **Hunziker, Max, Dr.**
**Chasseralstrasse 8**
**CH-3186 Düdingen (CH)**

## (54) Photoempfindliche Gemische.

(57) Flüssige photoempfindliche Zusammensetzung enthaltend, bezogen auf die Gesamtzusammensetzung,
(a) 10-50 Gew.-% eines Epoxydi(meth)acrylats und/oder eines Urethandi(meth)acrylats,
(b) 15-45 Gew.-% eines oder mehrerer bifunktioneller (Meth)acrylate mit einem Molekulargewicht zwischen 150 und 450,
(c) 0-20 Gew.-% eines trifunktionellen (Meth)acrylats,
(d) 0-10 Gew.-% N-Vinylpyrrolidon oder N-Vinylcaprolactam,
(e) 0- 10 Gew.-% eines monofunktionellen (Meth)acrylats,
(f) 15-30 Gew.-% eines oder mehrerer inerter Verdünner ausgewählt aus der Gruppe der $C_2$-$C_{12}$-Alkohole, $C_4$-$C_{12}$-Alkandiole, $C_4$-$C_{12}$-Dialkylketone, Polyalkylenglykole, Di- oder Triterpene, Hydroxyalkylester von β-Hydroxycarbonsäuren, Caprolactame, Chlorparaffine und Phthalsäurediester, Adipinsäurediester oder Citronensäureester erhältlich durch Reaktion von Phthalsäure, Adipinsäure oder Citronensäure mit $C_1$-$C_{12}$-Alkoholen, und
(g) 3-7 Gew.-% eines Photoinitiators,
können mittels aktinischer Strahlung polymerisiert werden und eignen sich insbesondere zur Herstellung von dreidimensionalen Gegenständen mittels Stereolithographie, welche als Modelle zur Herstellung von Keramikschalen für das investment casting-Verfahren verwendet werden können.

EP 0 536 086 A1

Die vorliegende Erfindung betrifft eine flüssige, photoempfindliche Zusammensetzung, ein Verfahren zur Herstellung von dreidimensionalen Gegenständen aus den flüssigen Zusammensetzungen sowie ein Verfahren zur Herstellung von Keramikschalen für das investment casting.

Ein übliches Verfahren zur Herstellung von dreidimensionalen gegossenen Metallgegenständen erfordert die Modellierung eines Prototyps aus Wachs, Kunstoffschäumen (z.B. Polystyrol) oder anderen schmelzbaren Kunstoffmischungen, welcher anschliessend mit einer Keramikmischung beschichtet wird. Beim darauffolgenden Ausbrennen der Keramik zersetzt sich der Wachs- bzw. Kunststoffkörper. Der gewünschte Metallgegenstand kann nun durch Eingiessen des Metalls in die Keramik-Negativ-Form hergestellt werden. Dieses Verfahren wird als investment casting oder als "Giessen in verlorene Formen" (Ullmanns Encyclopädie der technischen Chemie, 4. Auflage, Bd. 12, S. 273 ff.) bzw. Giessen nach dem Wachsausschmelzverfahren bezeichnet.

Die traditionelle Fertigung der im investment casting zum Einsatz gelangenden Modelle aus Wachs oder schmelzbaren Kunststoffen, zum Teil durch Handarbeit, ist sehr zeitaufwendig und teuer.

Das US-Patent 4,575,330 beschreibt die Herstellung von dreidimensionalen Gegenständen aus flüssigen, lichtempfindlichen Harzen mittels Stereolithographie. Das dort offenbarte photoempfindliche Gemisch, ein modifiziertes Acrylat, eignet sich jedoch nicht für das investment casting-Verfahren, da die thermische Ausdehnung des gehärteten Formkörpers beim Brennen der Keramik zu gross ist, was schliesslich zum Bruch der Keramikschale führt.

Die US-Patentschrift 4,844,144 offenbart photoempfindliche Gemische aus einem Poly(meth)acrylatharz gelöst in einem flüssigen Poly(meth)acrylat, einem Reaktiv-verdünner, einem Photoinitiator und einem thermoplastischen Oligomer, die sich für das investment casting-Verfahren eignen. Diese Gemische weisen allerdings eine relativ niedrige Photoempfindlichkeit auf, d.h. zur Härtung werden hohe Belichtungsenergien benötigt. Ausserdem muss bei den daraus hergestellten Modellen der Brennprozess der Keramikschale unter genau definierten Bedingungen durchgeführt werden, d.h. der Formkörper muss mit Hilfe eines Temperaturprogramms über eine lange Zeit stufenweise aufgeheizt werden, was Prozessdauern von 48 Stunden und mehr zur Folge hat und damit grosse Probleme in der Fertigung verursacht.

Es wurde nun gefunden, dass ein aus einem Epoxydi(meth)acrylat und/oder einem Urethandi(meth)acrylat, einem bifunktionellen (Meth)acrylat, einem Photoinitiator und einem inerten Verdünner bestehendes flüssiges Harzgemisch, welches gegebenenfalls ausserdem monofunktionelle und trifunktionelle (Meth)acrylate sowie N-Vinylpyrrolidon oder N-Vinylcaprolactam enthalten kann, eine hohe Photoempfindlichkeit aufweist und die daraus mittels Stereolithographie hergestellten Modelle problemlos im investment casting-Verfahren verwendet werden können.

Gegenstand der vorliegenden Erfindung ist eine flüssige, photoempfindliche Zusammensetzung enthaltend, bezogen auf die Gesamtzusammensetzung,

(a) 10-50 Gew.-% eines Epoxydi(meth)acrylats und/oder eines Urethandi(meth)acrylats,

(b) 15-45 Gew.-% eines oder mehrerer bifunktioneller (Meth)acrylate mit einem Molekulargewicht zwischen 150 und 450,

(c) 0-20 Gew.-% eines trifunktionellen (Meth)acrylats,

(d) 0-10 Gew.-% N-Vinylpyrrolidon oder N-Vinylcaprolactam,

(e) 0-10 Gew.-% eines monofunktionellen (Meth)acrylats,

(f) 15-30 Gew.-% eines oder mehrerer inerter Verdünner ausgewählt aus der Gruppe der $C_2$-$C_{12}$-Alkohole, $C_4$-$C_{12}$-Alkandiole, $C_4$-$C_{12}$-Dialkylketone, Polyalkylenglykole, Di- oder Triterpene, Hydroxyalkylester von β-Hydroxycarbonsäuren, Caprolactame, Chlorparaffine und Phthalsäurediester, Adipinsäurediester oder Citronensäureester erhältlich durch Reaktion von Phthalsäure, Adipinsäure oder Citronensäure mit $C_1$-$C_{12}$-Alkoholen, und

(g) 3-7 Gew.-% eines Photoinitiators.

Vorzugsweise enthält die erfindungsgemässe Zusammensetzung, bezogen auf die Gesamtzusammensetzung, 25-45 Gew.-% der Komponente (a), 20-45 Gew.-% der Komponente (b) und 5-20 Gew.-% der Komponente (c).

Als Epoxydi(meth)acrylate werden die Umsetzungsprodukte von Diglycidylverbindungen, beispielsweise Diglycidylethern von Diolen, mit (Meth)acrylsäure bezeichnet. Geeignet als Komponente (a) der erfindungsgemässen Zusammensetzungen sind zum Beispiel die durch Umsetzung von gegebenenfalls substituierten Bisphenol A- oder Bisphenol F-diglycidylethern mit (Meth)acrylsäure erhältlichen Acrylate. Solche monomeren oder oligomeren Di(meth)acrylate sind bekannt und zum Teil im Handel erhältlich.

Vorzugsweise wird Bisphenol A-diglycidyldiacrylat verwendet.

Die in den erfindungsgemässen Gemischen als Komponente (a) verwendbaren Urethandi(meth)acrylate sind dem Fachmann ebenfalls bekannt und können in bekannter Weise hergestellt werden, indem man beispielsweise ein dihydroxyterminiertes Polyurethan mit Acrylsäure oder Methacrylsäure zu dem entsprechenden Urethandi(meth)acrylat umsetzt, oder indem man ein diisocyanatterminiertes Präpolymer mit Hydroxyalkylacrylaten oder -methacrylaten zum Urethandi(meth)acrylat umsetzt. Entsprechende Verfahren werden beispielsweise in den EP-Patentanmeldungen 114982 und 133908 offenbart. Das Molekulargewicht (MG) solcher Acrylate liegt im allgemeinen im Bereich von 400 bis 10000, vorzugsweise zwischen 500 bis 7000.

Bevorzugt werden als Urethandi(meth)acrylate solche eingesetzt, die ein MG von 500-7000 aufweisen und aus aliphatischen Edukten hergestellt worden sind.

Als Verbindungen der Komponente (b) eignen sich beispielsweise die Diacrylat- und Dimethacrylatester von aliphatischen, cycloaliphatischen oder aromatischen Diolen, wie 1,3-Butylenglykol, 1,4-Butandiol, Neopentylglykol, 1,6-Hexandiol, Diethylenglykol, Triethylenglykol, Tetraethylenglykol, Tripropylenglykol, ethoxyliertes oder propoxyliertes Neopentylglykol, 1,4-Dihydroxymethylcyclohexan, 2,2-Bis-(4-hydroxycyclohexyl)-propan, Bis-(4-hydroxycyclohexyl)-methan, Hydrochinon, 4,4'-Dihydroxybiphenyl, Bisphenol A, Bisphenol F, Bisphenol S, ethoxyliertes oder propoxyliertes Bisphenol A, ethoxyliertes oder propoxyliertes Bisphenol F oder ethoxyliertes oder propoxyliertes Bisphenol S.

Solche Di(meth)acrylate sind ebenfalls bekannt und zum Teil im Handel erhältlich, beispielsweise unter der Produktbezeichnung SR-348 für ethoxyliertes Bisphenol A-dimethacrylat und unter der Produktbezeichnung SR-349 für ethoxyliertes Bisphenol A-diacrylat von der Firma SARTOMER Company.

Vorzugsweise wird als Komponente (b) ein Di(meth)acrylat von ethoxyliertem Bisphenol A und/oder Neopentylglykoldi(meth)acrylat verwendet.

Als Verbindungen der Komponente (c) eignen sich beispielsweise Triacrylate oder -methacrylate der Formeln I oder II

$$R^1\text{-}CH_2\text{-}C(CH_2\text{-}R^2)_3 \qquad (I),$$

$$R^2\text{-}CH(CH_2\text{-}R^2)_2 \qquad (II),$$

worin $R^1$ ein Wasserstoffatom, Methyl oder Hydroxyl bedeutet und $R^2$ einen Rest der Formel III darstellt

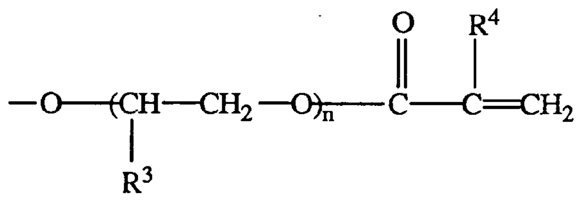 (III) ,

worin n für Null oder eine Zahl von 1-3 steht und $R^3$ und $R^4$ unabhängig voneinander je ein Wasserstoffatom oder Methyl bedeuten.

Von den Verbindungen der Formeln I und II sind solche der Formel I, worin $R^1$ eine Methylgruppe und $R^2$ einen Rest der Formel III bedeuten, worin n Null ist, besonders bevorzugt.

Als Komponente (c) können beispielsweise eingesetzt werden:

1,1,1-Trimethylolpropantriacrylat oder -methacrylat, ethoxyliertes 1,1,1-Trimethylolpropantriacrylat oder -methacrylat, Pentaerythritolmonohydroxytriacrylat oder -methacrylat. Solche Verbindungen sind bekannt und zum Teil im Handel erhältlich.

Insbesondere weisen die Verbindungen der Komponente (c) ein MG von 250 bis 500 auf.

Besonders bevorzugt als Komponente (c) ist Trimethylolpropantri(meth)acrylat.

Die erfindungsgemässen Zusammensetzungen können gegebenenfalls als Komponente (d) bis zu 10 Gew.-% N-Vinylpyrrolidon oder N-Vinylcaprolactam enthalten. Vorzugsweise wird N-Vinylpyrrolidon eingesetzt.

In den erfindungsgemässen Gemischen können als Komponente (e) beispielsweise folgende Verbindungen enthalten sein:

Allylacrylat, Allylmethacrylat, Methyl-, Ethyl-, n-Propyl-, n-Butyl-, Isobutyl-, n-Hexyl-, 2-Ethylhexyl-, n-Octyl-, n-Decyl- und n-Dodecylacrylat und -methacrylat, 2-Hydroxyethyl-, 2- und 3-Hydroxypropylacrylat und -methacrylat, 2-Methoxyethyl-, 2-Ethoxyethyl- und 2- oder 3-Ethoxypropylacrylat, Tetrahydrofurfurylmethacrylat, 2-(2-Ethoxyethoxy)ethylacrylat, Cyclohexylmethacrylat, 2-Phenoxyethylacrylat, 2-Phenoxyethylmethacrylat, Glycidylacrylat und Isodecylacrylat. Solche Produkte sind ebenfalls bekannt und zum Teil im Handel erhältlich, zum Beispiel von der Firma SARTOMER Company.

Besonders bevorzugt ist 2-Phenoxyethyl(meth)acrylat.

Beispiele für inerte Verdünner (Komponente (f)) der erfindungsgemässen Zusammensetzungen sind $C_2$-$C_{12}$-Alkohole, wie beispielsweise Isopropanol, Isobutanol oder insbesondere tert.-Butanol, und $C_4$-$C_{12}$-Alkandiole, wie z. B. 2,4-Dimethylpentan-2,4-diol, Pinakol oder vorzugsweise Pinakon. Weiterhin können $C_4$-$C_{12}$-Dialkylketone, wie z.B. 2,2-Dimethyl-3-pentanon oder insbesondere Pinakolon und Polyalkylenglykole, wie Diethylen-, Triethylen-, oder Tetraethylenglykol, Dipropylen-, Tripropylen- oder Tetrapropylenglykol oder Dibutylenglykol verwendet werden. Weitere geeignete inerte Verdünner sind Di- oder Triterpene, wie beispielsweise $\alpha$-Pinen, Campher, Limonen oder Menthol, Hydroxyalkylester von $\beta$-Hydroxycarbonsäuren, wie z.B. 2,2-Dimethyl-3-hydroxypropionsäure-2,2-dimethyl-3-hydroxypropylester, Caprolactame, wie $\varepsilon$-Caprolactam, Chlorparaffine, wie beispielsweise die von der Firma Hoechst AG unter der Bezeichnung Hordalub® vertriebenen chlorierten Paraffinkohlenwasserstoffe, und Phthalsäurediester, Adipinsäurediester oder Citronensäureester erhältlich durch Reaktion von Phthalsäure, Adipinsäure oder Citronensäure mit $C_1$-$C_{12}$-Alkoholen.

Vorzugsweise werden als Komponente (f) tert.-Butanol, Pinakon, Pinakolon, Dipropylenglykol, Triethylenglykol, Tripropylenglykol, $\alpha$-Pinen, Campher, Limonen, Menthol, Caprolactam, 2,2-Dimethyl-3-hydroxypropionsäure-2,2-dimethyl-3-hydroxypropylester, Adipinsäuredimethylester, Phthalsäurediethylester, Phthalsäure-bis-(2-methoxyethyl)ester oder Phthalsäurebis(2-ethylhexyl)ester eingesetzt.

Besonders bevorzugt als Komponente (f) sind Diethylen-, Triethylen- oder Tetraethylenglykol, Dipropylen-, Tripropylen- oder Tetrapropylenglykol, Dibutylenglykol, Caprolactam, Chlorparaffin, 2,2-Dimethyl-3-hydroxypropionsäure-2,2-dimethyl-3-hydroxypropylester und Phthalsäurediester oder Citronensäureester erhältlich durch Reaktion von Phthalsäure oder Citronensäure mit $C_3$-$C_{12}$-Alkoholen, insbesondere Phthalsäurebis(2-ethylhexyl)ester.

In den erfindungsgemässen Zusammensetzungen können alle Typen von Photoinitiatoren als Komponente (g) eingesetzt werden, welche bei der entsprechenden Bestrahlung freie Radikale bilden. Typische bekannte Photoinitiatoren sind Benzoine und Benzoinether, wie Benzoin, Benzoinmethylether, Benzoinethylether und Benzoinisopropylether, Benzoinphenylether und Benzoinacetat; Acetophenone, wie Acetophenon, $\alpha,\alpha$-Dimethoxyacetophenon und $\alpha,\alpha$-Dichloracetophenon; Benzil, Benzilketale, wie Benzildimethylketal und Benzildiethylketal; Anthrachinone, wie 2-Methylanthrachinon, 2-Ethylanthrachinon, 2-tert.-Butylanthrachinon, 1-Chloranthrachinon und 2-Amylanthrachinon; Triphenylphosphin; Benzoylphosphinoxide, wie beispielsweise 2,4,6-Trimethylbenzoyldiphenylphosphinoxid (Luzirin TPO); Benzophenone, wie Benzophenon und 4,4′-Bis-(N,N′-dimethylamino)-benzophenon; Xanthone und Thioxanthone wie z.B. 2-Isopropylthioxanthon; Acridinderivate; Phenazinderivate; Quinoxalinderivate oder 1-Phenyl-1,2-propandion-2-O-benzoyloxim; $\alpha$-Aminophenylketone, wie beispielsweise 1-(4-Methylthiophenyl)-2-methyl-2-morpholinobutan-1-on, oder 1-Hydroxyphenylketone, wie 1-Hydroxycyclohexylphenylketon, Phenyl-(1-hydroxyisopropyl)-keton und 4-Isopropylphenyl-(1-hydroxyisopropyl)-keton.

Geeignet sind auch Elektronentransfer-Initiatoren vom Typ der Xanthone, wie beispielsweise 2,4,5,7-Tetraiodo-6-hydroxy-9-cyano-3H-xanthen-3-on, die zusammen mit geeigneten Elektronendonatoren im sichtbaren Bereich des Spektrums eine hohe Reaktivität aufweisen.

Besonders geeignete Photoinitiatoren, welche gewöhnlich in Kombination mit einem HeCd-Laser als Strahlenquelle verwendet werden, sind Acetophenone, wie 2,2-Dialkoxybenzophenone, und $\alpha$-Hydroxyphenylketone, beispielsweise 1-Hydroxycyclohexylphenylketon oder (2-Hydroxyisopropyl)-phenylketon (= 2-Hydroxy-2,2-dimethylacetophenon).

Bevorzugte Photoinitiatoren sind Benzildimethylketal, 1-(4-Methylthiophenyl)-2-methyl-2-morpholinobutan-1-on, 2-Isopropylthioxanthon und insbesondere 1-Hydroxycyclohexylphenylketon.

Die erfindungsgemässen Gemische können auch verschiedene Photoinitiatoren enthalten, welche gegenüber Strahlen von Emissionslinien unterschiedlicher Wellenlängen verschieden strahlungsempfindlich sind. Man erreicht dadurch beispielsweise eine bessere Ausnützung einer UV/VIS-Lichtquelle, welche Emissionslinien unterschiedlicher Wellenlänge ausstrahlt. Vorteilhaft ist es dabei, wenn die verschiedenen Photoinitiatoren so ausgewählt und in einer solchen Konzentration eingesetzt werden, dass bei den verwendeten Emissionslinien eine gleiche optische Absorption erzeugt wird.

Falls erwünscht können den erfindungsgemässen Zusammensetzungen die üblichen Additive zugesetzt werden, beispielsweise Stabilisatoren, wie UV-Stabilisatoren, Polymerisationsinhibitoren, wie z.B. Hydrochinonmonomethylether, Trennmittel, Benetzungsmittel, Verlaufsmittel, Sensibilisatoren, Antiabsetzmittel, oberflächenaktive Mittel, Farbstoffe, Pigmente oder Füllstoffe.

Die erfindungsgemässen, photoempfindlichen Gemische können durch Bestrahlen mit aktinischem Licht, beispielsweise mittels Elektronen-, Röntgenstrahlen, UV- oder VIS-Licht, das heisst, mit Strahlen im Wellenlängenbereich von 280-650 nm, polymerisiert werden. Besonders geeignet sind Laserstrahlen von HeCd, Argon oder Stickstoff sowie Metalldampf und NdYAG-Laser mit vervielfachter Frequenz. Es ist dem Fachmann bekannt, dass für jede gewählte Lichtquelle der geeignete Photoinitiator ausgewählt und gegebenenfalls sensibilisiert werden muss. Man hat erkannt, dass die Eindringtiefe der Strahlen in die zu polymerisierende Zusammensetzung und die Arbeitsgeschwindigkeit in direktem Zusammenhang mit dem Absorptionskoeffizienten und der Konzentration des Photoinitiators stehen. In der Stereolithographie werden vorzugsweise solche Photoinitiatoren eingesetzt, welche die höchste Anzahl von entstehenden freien Radikalen bewirken und die grösste Strahlungseindringtiefe in die zu polymerisierenden Zusammensetzungen ermöglichen.

Ein weiterer Erfindungsgegenstand ist ein Verfahren zur Herstellung von dreidimensionalen Gegenständen aus den flüssigen, erfindungsgemässen Gemischen mittels stereolithographischen Verfahren, wobei die Oberfläche einer Schicht aus dem erfindungsgemässen, flüssigen Gemisch ganzflächig oder in einem vorbestimmten Muster mit UV-oder VIS-Licht bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

Bei diesem Verfahren wird als Strahlungsquelle bevorzugt ein Laserstrahl verwendet, der vorzugsweise computergesteuert ist.

Eine bevorzugte Anwendung der nach dem erfindungsgemässen Verfahren hergestellten dreidimensionalen Gegenstände ist die Verwendung als Modell im investment casting-Verfahren. Dabei wird der gehärtete Kunstoff-Formkörper mit einer Keramikschicht überzogen und anschliessend allmählich auf eine Temperatur oberhalb 500 °C, vorzugsweise auf ca. 800-1200 °C, erhitzt und mehrere Stunden bei dieser Temperatur belassen, wobei sich das Kunststoffmodell rückstandslos zersetzt. Die verbleibende Keramikschale eignet sich als Negativ-Form zur Herstellung von Formkörpern aus Metallen.
Die Beschichtung des mittels Stereolithographie hergestellten Kunststoffgegenstands mit Keramik erfolgt nach an sich bekannten Methoden, beispielsweise durch Eintauchen in eine flüssige Keramikmischung und anschliessende Trocknung. Das mit einer ersten Keramikschicht versehene Formteil wird dann vorzugsweise mit Quarz- oder Zirkonsand behandelt und erneut getrocknet. Durch mehrmalige Wiederholung dieses Vorgangs wird eine mehrere mm dicke Keramikschale erhalten.

In einer anderen Ausführungsform wird der Kunststoffgegenstand in einen geeigneten Behälter gestellt und die Keramikmasse um den Gegenstand herum in den Behälter gegossen (flask casting).

Ein weiterer Erfindungsgegenstand ist somit ein Verfahren zur Herstellung von Keramikschalen für das investment casting, dadurch gekennzeichnet, dass ein mittels Stereolithographie hergestellter Kunststoff-Formkörper mit Keramik beschichtet oder ummantelt wird, und der beschichtete Kunststoff-Formkörper anschliessend solange bei Temperaturen oberhalb 500 °C gebrannt wird, bis der Kunststoff rückstandslos zersetzt ist.

In einer bevorzugten Ausführungsform der Erfindung wird der beschichtete Kunststoff-Formkörper vor dem Ausbrennen einer Vakuumbehandlung unterzogen, wodurch die Prozessdauer erheblich verkürzt wird.

Ebenfalls Gegenstand vorliegender Erfindung ist somit ein Verfahren zur Herstellung von Keramikschalen für das investment casting, dadurch gekennzeichnet, dass ein mittels Stereolithographie hergestellter Kunststoff-Formkörper mit Keramik beschichtet wird und der beschichtete Formkörper im Vakuum bis zur vollständigen Entfernung des inerten Verdünners bei Temperaturen zwischen Raumtemperatur und 150 °C getempert und anschliessend bis zur rückstandslosen Zersetzung des Kunststoffs bei Temperaturen oberhalb 500 °C gebrannt wird.

Die aus den erfindungsgemässen Zusammensetzungen stereolithographisch hergestellten Erzeugnisse zeichnen sich durch gute anwendungstechnische Eigenschaften aus, insbesondere durch hohe Formtreue der Keramikschalen nach dem Ausbrennprozess.

Die folgenden Beispiele erläutern die Erfindung.

<u>Beispiel 1:</u>

40,4 g Bisphenol A-diglycidyldiacrylat werden bei 40 °C mit 20,7 g ethoxyliertem Bisphenol A-diacrylat (MG = 424, Produkt SR-349 der Firma SARTOMER Company), 10 g Trimethylolpropantrimethacrylat, 4 g 1-Hydroxycyclohexylphenylketon, 0,1 g Hydrochinonmonomethylether und 16,6 g Phthalsäure-bis-2-ethylhexylester gemischt. Die resultierende homogene, flüssige Mischung weist bei 30 °C eine Viskosität von 1510 mPa·s auf. Die Flüssigkeit wird mit einem ablenkbaren He/Cd Laserstrahl belichtet, wobei ein lasergehärteter Polymerfaden erhalten wird, dessen Dicke ein Mass für die Photoempfindlichkeit der betreffenden Mischung darstellt. Die Dicke des Fadens beträgt 0, 15 mm bei einer Belichtungsenergie von 20 mJ/cm$^2$, 0,29 mm bei einer Belichtungsenergie von 40 mJ/cm$^2$, 0,44 mm bei 80 mJ/cm$^2$ und 0,52 mm bei 160 mJ/cm$^2$. Ein aus diesem Gemisch mit einer Energie von 40 mJ/cm$^2$ gehärteter Formkörper weist im Zugversuch nach DIN 53371 einen Elastizitätsmodul (green strength) von 7,6 N/mm$^2$ auf. Nach der Aushärtung dieses sogenannten grünen Formkörpers durch Bestrahlung mit UV/VIS-Licht (ca. 30 Minuten, Hg-Lampe oder Fluoreszenzröhre) beträgt der Elastizitätsmodul 1440 N/mm$^2$. Die gemäss DIN 35455 gemessene Bruchdehnung beträgt 3,4 %.

Zur Prüfung des erfindungsgemässen Gemisches auf seine Eignung als Feinguss-Harz wird aus der Harzmischung das nachfolgend beschriebene Formteil hergestellt: Das Formteil besteht aus zwei nicht konzentrisch angeordneten, ineinanderliegenden Ringen, die durch 6 Stege miteinander verbunden sind. Das Teil hat

eine Höhe von 42 mm und einen äusseren Durchmesser von 129 mm. Es wird unten durch einen runden, hohlen Wulst abgeschlossen, welcher eine Höhe von 6 mm und eine Breite von 13 mm aufweist. Das Formteil besitzt unterschiedliche Wandstärken von 1 mm bis 2,5 mm und wiegt 77 g. Das Teil wird ca. eine halbe Minute in eine handelsübliche flüssige Keramikmischung eingetaucht und anschliessend an der Luft getrocknet, bis das so erhaltene keramikbeschichtete Formteil nur noch leicht feucht ist. Das so erhaltene keramikbeschichtete Formteil wird anschliessend mit Quarzsand behandelt und an der Luft getrocknet. Dieser Vorgang wird 15mal wiederholt. Die auf diese Weise auf das Formteil aufgebrachte Keramikschale ist ca. 6-8 mm dick.
Das keramikbeschichtete Kunststoff-Formteil wird in einem programmierbaren Ofen während 8 Stunden von 100 °C auf 800 °C erhitzt, wobei sich der Kunststofformkörper vollständig zersetzt. Nach Abkühlen auf Raumtemperatur wird die so erhaltene Keramikschale mit einer Lupe auf Risse geprüft. Der Grad der Unversehrtheit wird mit einer Note von 1-5 bewertet, wobei Schalen mit Noten von 1-3 im anschliessenden Giessprozess verwendet werden können:

1: Keine Risse - erfolgreicher Ausbrennprozess.
2: Nur Haarrisse - die Schale kann leicht repariert werden.
3: Kleine Risse - die Schale ist reparierbar.
4: Grosse Risse - Teile der Schale sind abgesprungen, nicht reparierbar.
5: Schale auseinandergefallen.

Aus 2 kg der oben angegebenen Harzmischung werden in einer SLA-250 Maschine der Firma 3D-Systems zwei der beschriebenen Formteile hergestellt und anschliessend in eine flüssige Keramikmischung eingetaucht und besandet. Durch mehrfaches Wiederholen dieses Prozesses wird so eine 8 mm dicke Keramikschale aufgebracht. Die keramikbeschichteten Kunststoff-Formteile werden in einem programmierbaren Ofen während 8 Stunden von 100 °C auf 800 °C erhitzt, wobei sich die Kunststofformkörper rückstandsfrei zersetzen. Die so erhaltenen Keramikschalen werden mit der Note 2 bewertet.

Beispiele 2-11:

Analog zum im Beispiel 1 beschriebenen Verfahren werden aus den in Tabelle 2 angegebenen Zusammensetzungen Kunstoff-Formkörper hergestellt, mit Keramik beschichtet und im Ofen gebrannt. Die Eigenschaften der gehärteten Formkörper und der damit hergestellten Keramikschalen sind in Tabelle 2 aufgeführt.

Tabelle 1: Zusammensetzungen der Beispiele 1-11 (Mengenangaben in g)

| Beispiel | 1 | 2 | 3 | 4 | 5 | 6 | 7 | 8 | 9 | 10 | 11 |
|---|---|---|---|---|---|---|---|---|---|---|---|
| Bisphenol A-diglycidyldiacrylat | 40,40 | 44,27 | 30,40 | 40,40 | 40,40 | 40,40 | 29,60 | 29,60 | | | 29,85 |
| Ethoxyliertes Bisphenol A-dimethacrylat | 20,70 | 22,70 | 15,50 | 20,70 | 20,70 | 20,70 | 4,10 | 4,10 | | | 4,00 |
| Trimethylolpropantrimethacrylat | 10,0 | 10,9 | 7,5 | 10,00 | 10,00 | 10,00 | 4,10 | 4,10 | 4,50 | 4,50 | 4,00 |
| N-Vinylpyrrolidon | 4,1 | 4,5 | 3,1 | 4,1 | 4,1 | 4,1 | 5,8 | 5,8 | | | |
| Phenoxyethylacrylat | 4,1 | 4,5 | 3,1 | 4,1 | 4,1 | 4,1 | 4,1 | 4,1 | | | 5,0 |
| 1-Hydroxycyclohexylphenylketon | 4,0 | 4,0 | 3,0 | 4,0 | 4,0 | 4,0 | 5,0 | 5,0 | 4,9 | 4,9 | 5,0 |
| Hydrochinonmonomethylether | 0,1 | 0,13 | 0,1 | 0,1 | 0,1 | 0,1 | 0,1 | 0,1 | 0,1 | 0,1 | 0,15 |
| Urethanacrylat C 9504 der Fa. Sartomer) | | | 12,40 | | | | | | 32,60 | 32,60 | |
| Butandioldiacrylat | | | | | | | | | 8,90 | 8,90 | |
| Ethoxyliertes Bisphenol A-diacrylat | | | | | | | 20,70 | 20,70 | 32,50 | 32,50 | 20,00 |
| Trimethylolpropantriacrylat | | | | | | | 10,00 | 10,00 | | | 9,00 |
| Neopentylglykoldimethacrylat | | | | | | | | | | | 6,00 |
| Polyurax® U 1102 *) | | | 24,90 | | | | | | | | |
| Phthalsäure-bis(2-methoxyethyl)ester | | | | 16,40 | | | | | | | |
| Hordalub® 80 HT **) | | | | | 16,40 | | | | | | |
| Caprolactam | | | | | | 16,40 | | 16,50 | | 16,50 | |
| Phthalsäure-bis(2-ethylhexyl)ester | 16,6 | 9,0 | | | | | 16,50 | | 16,50 | | 17,00 |

*) Polymeres Polyol der Fa. BP Chemicals
**) Chlorparaffin der Fa. Hoechst

Tabelle 2:

| Beispiel | 1 | 2 | 3 | 4 | 5 | 6 | 7 | 8 | 9 | 10 | 11 |
|---|---|---|---|---|---|---|---|---|---|---|---|
| Viskosität der flüssigen Mischung bei 35 °C [mPa · s] | 460 | 700 | 1720 | 379 | 969 | 748 | 407 | 556 | 818 | 1040 | 458 (30 °C) |
| Dicke des Polymerfadens nach Bestrahlung mit 20 $mJ/cm^2$ [mm] | 0,15 | 0,15 | | 0,19 | 0,17 | 0,22 | 0,17 | 0,24 | | 0,22 | |
| 40 $mJ/cm^2$ | 0,29 | 0,29 | 0,31 | 0,30 | 0,32 | 0,36 | 0,27 | 0,34 | 0,27 | 0,33 | 0,23 |
| 80 $mJ/cm^2$ | 0,44 | 0,43 | 0,42 | 0,42 | 0,42 | 0,50 | 0,39 | 0,47 | 0,41 | 0,46 | 0,34 |
| 160 $mJ/cm^2$ | 0,52 | 0,57 | 0,52 | 0,55 | 0,56 | 0,65 | 0,51 | 0,57 | 0,52 | 0,56 | 0,47 |
| Elastizitätsmodul [$N/mm^2$] (nach Bestrahlung mit 40 $mJ/cm^2$) | 7,6 | 22,1 | | 3,0 | 18,0 | 18,0 | 25,0 | 34,0 | 1,8 | 3,4 | 2,3 |
| Eigenschaften nach UV/VIS-Härtung | | | | | | | | | | | |
| Elastizitätsmodul [$N/mm^2$] | 1440 | 1860 | 782 | 1365 | 1430 | 1361 | 1500 | 1360 | 450 | 370 | 1564 |
| Bruchdehnung [%] | 3,4 | 2,9 | 6,7 | 5,7 | 5,2 | 5,0 | 4,7 | 6,8 | 9,0 | 12,0 | 5,0 |
| Qualität der gebrannten Keramikschale *) | 2 | 3 | 2 | 1,5-2 | 1,5 | 1,5-2 | 1 | 2 | 1,5 | 2 | |

*) 1: keine Risse - erfolgreicher Ausbrennprozess
2: nur Haarrisse - die Schale kann leicht repariert werden
3: kleine Risse - die Schale kann repariert werden

Beispiele 12-33:

Die in den Tabellen 3 und 5 angegebenen Zusammensetzungen der Beispiele 12-33 werden analog zu Beispiel 1 hergestellt und getestet. Die Mischungen der Beispiele 12-17 und 24-33 werden, wie in Beispiel 1,

mit einem He/Cd-Laserstrahl belichtet, während in den Beispielen 18-23 ein ablenkbarer Ar-UV-Laserstrahl verwendet wird. Die Resultate der Tests sind in den Tabellen 4 und 6 aufgeführt.

Die so hergestellten flüssigen Mischungen werden zwischen zwei Glasplatten durch Bestrahlung mit UV/VIS-Licht (ca. 30 min, Hg-Lampe oder Fluoreszenzröhre) gehärtet. Anschliessend werden die gehärteten Harzplatten zu Mustern von 70-150 mm Länge, 20-30 mm Breite und 2 mm Dicke zersägt. Diese Harzplättchen werden wie in Beispiel 1 beschrieben mit zwei Schichten einer flüssigen Keramikmischung beschichtet, wobei zum Besanden Zirkonsand (100 mesh) verwendet wird. Anschliessend werden, unter Verwendung von Fused Silica (50 mesh) zum Besanden, fünf weitere Keramikschichten aufgebracht. Nach dem Trocknen der Harzplättchen beträgt die Dicke der Keramikschicht ca. 5-6 mm. Die auf diese Weise beschichteten Platten werden in einem programmierbaren Ofen innerhalb von 13 h auf 900 °C erhitzt und anschliessend noch 1 h bei dieser Temperatur belassen, wobei die Keramikschale ihre endgültige Festigkeit erhält. Die Kunststoffplättchen haben sich während des Aufheizprozesses rückstandslos zersetzt. Nach Abkühlen auf Raumtemperatur werden die so erhaltenen Keramikschalen mit einer Lupe auf Risse geprüft. Der Grad der Unversehrtheit wird wie in Beispiel 1 beschrieben mit einer Note von 1-5 beurteilt. Die Resultate sind in den Tabellen 4 und 6 angegeben.

Tabelle 3: Zusammensetzungen der Beispiele 12-23 (Mengenangaben in g)

| Beispiel | 12 | 13 | 14 | 15 | 16 | 17 | 18 | 19 | 20 | 21 | 22 | 23 |
|---|---|---|---|---|---|---|---|---|---|---|---|---|
| Bisphenol A-diglycidyldiacrylat | 30,35 | 30,35 | 30,35 | 30,35 | 30,35 | 30,35 | 31,26 | 30,94 | 30,63 | 31,55 | 30,78 | 31,22 |
| Ethoxyliertes Bisphenol A-dimethacrylat | 20,50 | 20,50 | 20,50 | 20,50 | 20,50 | 20,50 | 21,11 | 20,90 | 20,69 | 21,31 | 20,79 | 21,09 |
| Ethoxyliertes Bisphenol A-diacrylat | 9,00 | 9,00 | 9,00 | 9,00 | 9,00 | 9,00 | 9,27 | 9,17 | 9,08 | 9,36 | 9,13 | 9,26 |
| Trimethylolpropantrimethacrylat | 9,00 | 9,00 | 9,00 | 9,00 | 9,00 | 9,00 | 9,27 | 9,17 | 9,08 | 9,36 | 9,13 | 9,26 |
| Trimethylolpropantriacrylat | 4,00 | 4,00 | 4,00 | 4,00 | 4,00 | 4,00 | 4,12 | 4,08 | 4,04 | 4,16 | 4,06 | 4,12 |
| 2-Phenoxyethylacrylat | 5,00 | 5,00 | 5,00 | 5,00 | 5,00 | 5,00 | 5,15 | 5,10 | 5,05 | 5,20 | 5,07 | 5,14 |
| Phthalsäure-bis(2-ethylhexyl)ester | 17,00 | 13,60 | 10,20 | 6,80 | 3,40 | | 17,51 | 17,33 | 17,15 | 17,67 | 17,24 | 17,49 |
| 2,2-Dimethyl-3-hydroxypropionsäure-2,2-dimethyl-3-hydroxypropylester | | 3,40 | 6,80 | 10,20 | 13,60 | 17,00 | | | | | | |
| Hydrochinonmonomethylether | 0,15 | 0,15 | 0,15 | 0,15 | 0,15 | 0,15 | 0,15 | 0,15 | 0,15 | 0,16 | 0,15 | 0,15 |
| 1-Hydroxycyclohexylphenylketon | 5,00 | 5,00 | 5,00 | 5,00 | 5,00 | 5,00 | | | | | | |
| Benzildimethylketal | | | | | | | 2,16 | 3,16 | 4,14 | | | 2,16 |
| [1-(4-Methylthio)phenyl]-2-methyl-2-morpholino-butan-1-on | | | | | | | | | | 1,25 | 3,65 | |
| 2-Isopropylthioxanthon | | | | | | | | | | | | 0,10 |

Tabelle 4:

| Beispiel | 12 | 13 | 14 | 15 | 16 | 17 | 18 | 19 | 20 | 21 | 22 | 23 |
|---|---|---|---|---|---|---|---|---|---|---|---|---|
| Viskosität der flüssigen Mischung bei 35 °C [mPa · s] | 670 | 683 | 738 | 798 | 895 | 965 | 765 | 770 | 770 | 770 | 795 | 760 |
| Dicke des Polymerfadens nach Bestrahlung mit 20 $mJ/cm^2$ [mm] | 0,12 | 0,13 | 0,13 | 0,15 | 0,13 | 0,13 | 0,29 | 0,26 | 0,24 | 0,24 | 0,15 | 0,18 |
| 40 $mJ/cm^2$ | 0,24 | 0,25 | 0,24 | 0,26 | 0,25 | 0,24 | 0,42 | 0,36 | 0,32 | 0,46 | 0,22 | 0,26 |
| 80 $mJ/cm^2$ | 0,34 | 0,36 | 0,35 | 0,36 | 0,35 | 0,35 | 0,65 | 0,51 | 0,43 | 0,73 | 0,32 | 0,36 |
| 160 $mJ/cm^2$ | 0,44 | 0,47 | 0,46 | 0,47 | 0,46 | 0,46 | 0,79 | 0,60 | 0,52 | 1,05 | 0,45 | 0,45 |
| Elastizitätsmodul [$N/mm^2$] nach Bestrahlung mit 40 $mJ/cm^2$ | 7,5 | 5,9 | 6,7 | 10,2 | 8,0 | 9,0 | 5,5 | 7,5 | 11,4 | | 4,7 | 3,6 |
| nach Bestrahlung mit 80 $mJ/cm^2$ | 72,6 | 56,2 | 61,7 | 64,5 | 57,6 | 90,1 | 44,8 | 46,2 | 53,4 | 4,8 | 28,1 | 19,7 |
| Eigenschaften nach UV/VIS-Härtung Elastizitätsmodul [$N/mm^2$] | 1430 | 1328 | 1369 | 1436 | 1450 | 1523 | 1310 | 1440 | 1490 | 880 | 1200 | 1200 |
| Bruchdehnung [%] | 3,8 | 5,7 | 7,7 | 6,5 | 6,1 | 5,6 | 7,5 | 6,6 | 4,4 | 7,0 | 5,7 | 4,9 |
| Qualität der gebrannten Keramikschale | 1 | 1 | 1 | 1 | 1 | 1 | 1 | 1 | 1 | 1 | 1 | 1 |

Tabelle 5: Zusammensetzungen der Beispiele 24-33 (Mengenangaben in g)

| Beispiel | 24 | 25 | 26 | 27 | 28 | 29 | 30 | 31 | 32 | 33 |
|---|---|---|---|---|---|---|---|---|---|---|
| Bisphenol A-diglycidyldiacrylat | 29,20 | 29,20 | 29,20 | 29,20 | 29,20 | 29,20 | 29,20 | 29,20 | 29,20 | 29,20 |
| Ethoxyliertes Bisphenol A-dimethacrylat | 19,70 | 19,70 | 19,70 | 19,70 | 19,70 | 19,70 | 19,70 | 19,70 | 19,70 | 19,70 |
| Ethoxyliertes Bisphenol A-diacrylat | 8,70 | 8,70 | 8,70 | 8,70 | 8,70 | 8,70 | 8,70 | 8,70 | 8,70 | 8,70 |
| Trimethylolpropantrimethacrylat | 8,70 | 8,70 | 8,70 | 8,70 | 8,70 | 8,70 | 8,70 | 8,70 | 8,70 | 8,70 |
| Trimethylolpropantriacrylat | 3,90 | 3,90 | 3,90 | 3,90 | 3,90 | 3,90 | 3,90 | 3,90 | 3,90 | 3,90 |
| 2-Phenoxyethylacrylat | 4,80 | 4,80 | 4,80 | 4,80 | 4,80 | 4,80 | 4,80 | 4,80 | 4,80 | 4,80 |
| Phthalsäurediethylester | 20,00 | | | | | | | | | |
| Adipinsäuredimethylester | | 20,00 | | | | | | | | |
| Dipropylenglykol | | | 20,00 | | | | | | | |
| Pinakon | | | | 20,00 | | | | | | |
| Pinakolon | | | | | 20,00 | | | | | |
| tert.-Butanol | | | | | | 20,00 | | | | |
| α-Pinen | | | | | | | 20,00 | | | |
| Campher | | | | | | | | 20,00 | | |
| Limonen | | | | | | | | | 20,00 | |
| Menthol | | | | | | | | | | 20,00 |
| 1-Hydroxycyclohexylphenylketon | 5,00 | 5,00 | 5,00 | 5,00 | 5,00 | 5,00 | 5,00 | 5,00 | 5,00 | 5,00 |
| Hydrochinonmonomethylether | 0,15 | 0,15 | 0,15 | 0,15 | 0,15 | 0,15 | 0,15 | 0,15 | 0,15 | 0,15 |

Tabelle 6:

| Beispiel | 24 | 25 | 26 | 27 | 28 | 29 | 30 | 31 | 32 | 33 |
|---|---|---|---|---|---|---|---|---|---|---|
| Viskosität der flüssigen Mischung bei 35 °C [mPa · s] | 351 | 127 | 409 | 414 | 91 | 326 | 180 | 533 | 84 | 372 |
| Dicke des Polymerfadens nach Bestrahlung mit 20 mJ/cm$^2$ [mm] | | | 0,12 | 0,15 | | 0,19 | 0,15 | | | |
| 40 mJ/cm$^2$ | 0,23 | 0,30 | 0,24 | 0,24 | 0,23 | 0,23 | 0,22 | 0,27 | | |
| 80 mJ/cm$^2$ | 0,34 | 0,40 | 0,34 | 0,33 | 0,34 | 0,31 | 0,32 | 0,31 | | 0,25 |
| 160 mJ/cm$^2$ | 0,43 | 0,29 | 0,44 | 0,43 | 0,42 | 0,44 | 0,44 | 0,44 | | 0,37 |
| 320 mJ/cm$^2$ | | | | | | | | | | 0,53 |
| Elastizitätsmodul [N/mm$^2$] nach Bestrahlung mit 40 mJ/cm$^2$ | 3,4 | 3,0 | 4,3 | 4,6 | 4,0 | 10,1 | 6,4 | 5,4 | | |
| nach Bestrahlung mit 80 mJ/cm$^2$ | 18,1 | 32,3 | 21,9 | 34,5 | 37,7 | 95,8 | 43,8 | 40,6 | | |
| Eigenschaften nach UV/VIS-Härtung Elastizitätsmodul [N/mm$^2$] | 453 | 1081 | 837 | 1996 | 3675 | 2130 | 2173 | 2112 | | |
| Bruchdehnung [%] | 7,8 | 3,3 | 9,0 | 3,7 | 3,2 | 3,6 | 4,3 | 3,8 | | |
| Qualität der gebrannten Keramikschale | 1 | 1 | 1 | 1 | 1 | 1 | 1 | 1 | 1 | 1 |

## Patentansprüche

1. Flüssige photoemfindliche Zusammensetzung enthaltend, bezogen auf die Gesamtzusammensetzung,
   (a) 10-50 Gew.-% eines Epoxydi(meth)acrylats und/oder eines Urethandi(meth)acrylats,
   (b) 15-45 Gew.-% eines oder mehrerer bifunktioneller (Meth)acrylate mit einem Molekulargewicht zwischen 150 und 450,
   (c) 0-20 Gew.-% eines trifunktionellen (Meth)acrylats,

(d) 0-10 Gew.-% N-Vinylpyrrolidon oder N-Vinylcaprolactam,

(e) 0-10 Gew.-% eines monofunktionellen (Meth)acrylats,

(f) 15-30 Gew.-% eines oder mehrerer inerter Verdünner ausgewählt aus der Gruppe der $C_2$-$C_{12}$-Alkohole, $C_4$-$C_{12}$-Alkandiole, $C_4$-$C_{12}$-Dialkylketone, Polyalkylenglykole, Di- oder Triterpene, Hydroxyalkylester von β-Hydroxycarbonsäuren, Caprolactame, Chlorparaffine und Phthalsäurediester, Adipinsäurediester oder Citronensäureester erhältlich durch Reaktion von Phthalsäure, Adipinsäure oder Citronensäure mit $C_1$-$C_{12}$-Alkoholen, und

(g) 3-7 Gew.-% eines Photoinitiators.

2. Zusammensetzung gemäss Anspruch 1, enthaltend, bezogen auf die Gesamtzusammensetzung, 25-45 Gew.-% der Komponente (a), 20-45 Gew.-% der Komponente (b) und 5-20 Gew.-% der Komponente (c).

3. Zusammensetzung gemäss Anspruch 1, enthaltend als Komponente (a) Bisphenol A-diglycidyldiacrylat.

4. Zusammensetzung gemäss Anspruch 1, enthaltend als Komponente (b) ein Di(meth)acrylat von ethoxyliertem Bisphenol A und/oder Neopentylglykoldi(meth)acrylat.

5. Zusammensetzung gemäss Anspruch 1, enthaltend als Komponente (c) Trimethylolpropantri(meth)acrylat.

6. Zusammensetzung gemäss Anspruch 1, enthaltend als Komponente (e) Phenoxyethyl(meth)acrylat.

7. Zusammensetzung gemäss Anspruch 1, enthaltend als Komponente (f) einen inerten Verdünner ausgewählt aus der Gruppe bestehend aus tert.-Butanol, Pinakon, Pinakolon, Dipropylenglykol, Triethylenglykol, Tripropylenglykol, α-Pinen, Campher, Limonen, Menthol, Caprolactam, 2,2-Dimethyl-3-hydroxypropionsäure-2,2-dimethyl-3-hydroxypropylester, Adipinsäuredimethylester, Phthalsäurediethylester, Phthalsäure-bis-(2-methoxyethyl)ester oder Phthalsäurebis(2-ethylhexyl)ester.

8. Zusammensetzung gemäss Anspruch 1, enthaltend als Komponente (f) einen inerten Verdünner ausgewählt aus der Gruppe bestehend aus Diethylen-, Triethylen- oder Tetraethylenglykol, Dipropylen-, Tripropylen- oder Tetrapropylenglykol, Dibutylenglykol, Caprolactam, Chlorparaffin, 2,2-Dimethyl-3-hydroxypropionsäure-2,2-dimethyl-3-hydroxypropylester und Phthalsäurediester oder Citronensäureester erhältlich durch Reaktion von Phthalsäure oder Citronensäure mit $C_3$-$C_{12}$-Alkoholen.

9. Zusammensetzung gemäss Anspruch 1, enthaltend als Komponente (g) Benzildimethylketal, 1-(4-Methylthiophenyl)-2-methyl-2-morpholinobutan-1-on, 2-Isopropylthioxanthon oder 1-Hydroxycyclohexylphenylketon.

10. Zusammensetzung gemäss Anspruch 1, enthaltend als Komponente (g) 1-Hydroxycyclohexylphenylketon.

11. Verfahren zur Herstellung von dreidimensionalen Gegenständen aus einem flüssigen, photoempfindlichen Gemisch gemäss Anspruch 1 mittels stereolithographischen Verfahren, wobei die Oberfläche einer Schicht aus dem erfindungsgemässen, flüssigen Gemisch ganzflächig oder in einem vorbestimmten Muster mit UV- oder VIS-Licht bestrahlt wird, so dass sich in den bestrahlten Bereichen eine Schicht in einer gewünschten Schichtdicke verfestigt, dann eine neue Schicht aus den erfindungsgemässen Gemischen auf der verfestigten Schicht gebildet wird, die ebenfalls ganzflächig oder in einem vorbestimmten Muster bestrahlt wird, und wobei durch wiederholtes Beschichten und Bestrahlen dreidimensionale Gegenstände aus mehreren aneinander haftenden, verfestigten Schichten erhalten werden.

12. Verfahren gemäss Anspruch 11, worin als Strahlenquelle ein Laserstrahl, vorzugsweise ein computergesteuerter Laserstrahl, verwendet wird.

13. Verfahren zur Herstellung von keramikschalen für das investment casting, dadurch gekennzeichnet, dass ein mittels Stereolithographie nach Anspruch 11 hergestellter Kunststoff-Formkörper mit Keramik beschichtet oder ummantelt wird, und der beschichtete Formkörper anschliessend solange bei Temperaturen oberhalb 500 °C gebrannt wird, bis der Kunststoff rückstandslos zersetzt ist.

14. Verfahren zur Herstellung von keramikschalen für das investment casting, dadurch gekennzeichnet, dass ein mittels Stereolithographie nach Anspruch 11 hergestellter Kunststoff-Formkörper mit Keramik beschichtet wird und der beschichtete Formkörper im Vakuum bis zur vollständigen Entfernung des inerten Verdünners bei Temperaturen zwischen Raumtemperatur und 150 °C getempert und anschliessend bis zur rückstandslosen Zersetzung des Kunststoffs bei Temperaturen oberhalb 500 °C gebrannt wird.

Europäisches Patentamt

# EUROPÄISCHER RECHERCHENBERICHT

Nummer der Anmeldung
EP 92 81 0728

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
| A,D | WO-A-9 001 727 (DESOTO,INC.)<br>* Seite 14, Zeile 1 - Zeile 20 *<br>* Seite 17 *<br>* Seite 18, Zeile 1; Ansprüche *<br>--- | 1-14 | G03F7/027<br>G03F7/004<br>G03C9/08 |
| A | EP-A-0 003 040 (INTERNATIONAL BUSINESS MACHINES CORPORATION)<br>* Seite 5 *<br>* Seite 9, Zeile 15 - Zeile 20 *<br>* Seite 10, Zeile 1 - Zeile 24 *<br>* Seite 11, Zeile 4 - Zeile 6 *<br>--- | 1-10 | |
| A | US-A-4 271 258 (K. WATARIGUCHI)<br>* Ansprüche *<br>--- | 1-10 | |
| A | EP-A-0 393 676 (E.I. DU PONT DE NEMOURS AND COMPANY)<br>* Seite 5, Zeile 33 - Zeile 35 *<br>* Seite 5, Zeile 43 *<br>* Seite 5, Zeile 48 *<br>* Seite 6, Zeile 3 *<br>* Seite 6, Zeile 8 *<br>* Seite 9, Zeile 34 *<br>----- | 1-14 | RECHERCHIERTE SACHGEBIETE (Int. Cl.5 )<br>G03F<br>G03C |

Der vorliegende Recherchenbericht wurde für alle Patentansprüche erstellt

| Recherchenort | Abschlußdatum der Recherche | Prüfer |
|---|---|---|
| DEN HAAG | 13 JANUAR 1993 | DUPART J-M.B. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)